(19) **Europäisches Patentamt / European Patent Office / Office européen des brevets**

(11) **EP 2 131 269 A1**

(12) **EUROPEAN PATENT APPLICATION**
published in accordance with Art. 153(4) EPC

(43) Date of publication:
**09.12.2009 Bulletin 2009/50**

(51) Int Cl.:
*G06F 3/041* (2006.01)  *G06F 3/045* (2006.01)
*H01H 13/04* (2006.01)  *H01H 13/712* (2006.01)

(21) Application number: **08722714.6**

(22) Date of filing: **24.03.2008**

(86) International application number:
**PCT/JP2008/055398**

(87) International publication number:
**WO 2008/117770 (02.10.2008 Gazette 2008/40)**

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **26.03.2007  JP 2007078159**

(71) Applicant: **NISSHA PRINTING CO., LTD.**
**Nakagyo-ku**
**Kyoto-shi**
**Kyoto 604-8551 (JP)**

(72) Inventors:
• **NAKAMURA, Kazuto**
**Kyoto-shi**
**Kyoto 604-8551 (JP)**
• **HASHIMOTO, Takao**
**Kyoto-shi**
**Kyoto 604-8551 (JP)**
• **NISHIKAWA, Kazuhiro**
**Kyoto-shi**
**Kyoto 604-8551 (JP)**

• **KAI, Yoshihiro**
**Kyoto-shi**
**Kyoto 604-8551 (JP)**
• **KUSUDA, Yasuji**
**Kyoto-shi**
**Kyoto 604-8551 (JP)**
• **ASAKURA, Takeshi**
**Kyoto-shi**
**Kyoto 604-8551 (JP)**
• **MUROI, Hideyuki**
**Kyoto-shi**
**Kyoto 604-8551 (JP)**
• **OKAMOTO, Koji**
**Kyoto-shi**
**Kyoto 604-8551 (JP)**

(74) Representative: **Müller-Boré & Partner**
**Patentanwälte**
**Grafinger Strasse 2**
**81671 München (DE)**

(54) **PROTECTIVE PANEL WITH TOUCH INPUT FUNCTION OF ELECTRONIC INSTRUMENT DISPLAY WINDOW**

(57) A protection panel with a touch input function for an electronic instrument display window, which is excellent in reliability in an FPC connection. The panel is constituted such that the outer side face can be fitted into a panel fitting part of a casing having an aperture and kept without a gap to form a leveled plane and is configured to protect a display device provided under it externally visibly through a transparent window. A pin-equipped FPC (10) for taking out electric signals via through holes from the rear of the protective panel is **characterized in that** a metal pin fixation hole (10e) is bored on a film substrate (10f) and a circuit (10c) serving as a conductive part at a connection terminal (10a) of the FPC; a metal pin (14) having an axis part (14b) and a head part (14a) formed in a larger diameter than the outer diameter of the pin axis part is inserted into the metal pin fixation hole from the circuit side; a cover-lay film (10b) is stuck onto the circuit (10c) and the film substrate (10f) to cover the head part of the metal pin and also a conductive adhesive layer (21) is interposed between the circuit (10c) and the head part of the metal pin (14).

EP 2 131 269 A1

Fig.1

## Description

TECHNICAL FIELD

The present invention relates to a protection panel for display windows of portable information terminals such as PDA and handy terminals, OA appliances such as copying machines and facsimiles, smart phones, mobile phones, portable game consoles, electronic dictionaries, automotive navigation systems, compact PC, various kinds of home appliances, etc., and more specifically, a protection panel with a touch input function for electronic instrument display windows which can improve the reliability of an FPC connection part therein.

BACKGROUND ART

A casing in electronic instruments such as mobile phones, smart phones and the like is generally constituted by combining a front casing and a rear casing made of synthetic resins.

Concretely, a protection panel for protecting a liquid crystal display window is fixed in the surface of the front casing by fusion-bonding or the like. For the protection panel, conventionally, colorless transparent resin panels have been used; however along with the tendency of making electronic instruments fashionable, decoration such as fringing by printing or the like has been applied.

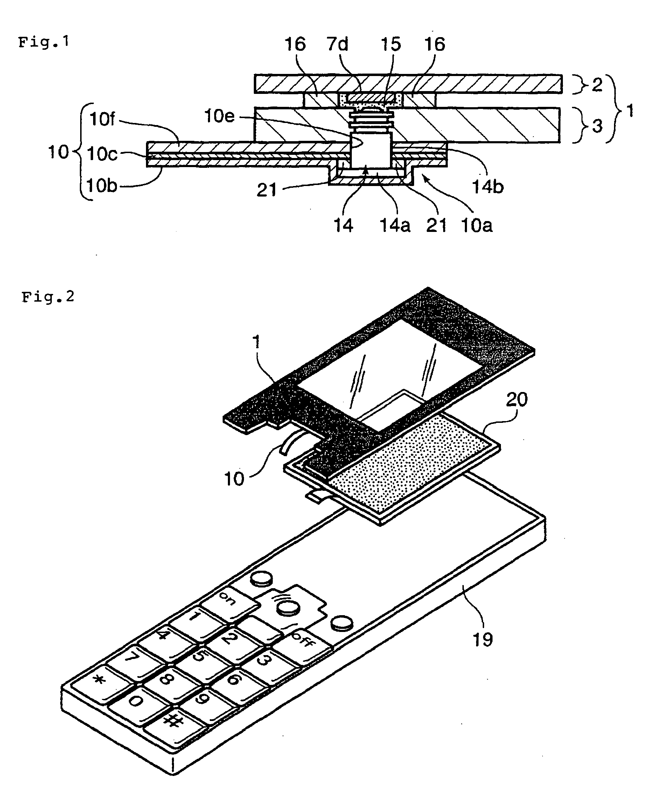

Further, in recent years, as disclosed, for example, in Pamphlet of International Publication WO 2005/064451, those equipped with an input device function to a protection panel 1 have highly been expected as next interfaces for mobile phones (see Fig. 2). In addition, in the drawing, the reference numeral 10 denotes an FPC (Flexible Printed Circuit) connected to an input device; 19 denotes a main body; and 20 denotes a display.

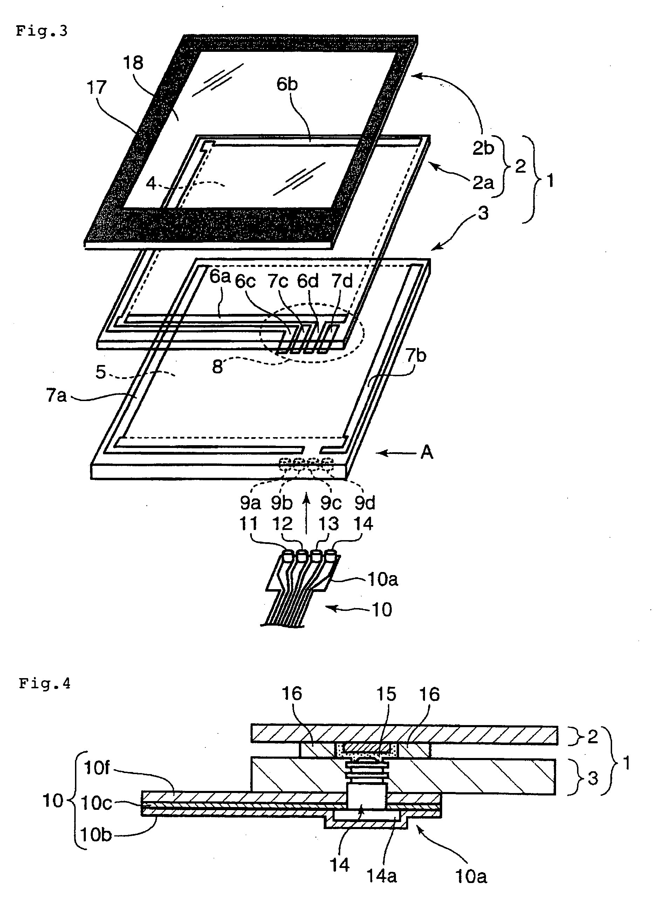

Regarding the configuration of this kind protection panel with a touch input function for electronic instrument display windows (hereinafter, referred to as a protection panel with a touch input function, for short) 1, the configuration will be described further in detail with reference to Fig. 3, an exploded perspective drawing.

In this drawing, the protection panel with a touch input function 1 is constituted with a lower electrode panel 3, an upper electrode sheet 2a, and a decoration sheet 2b.

The lower electrode panel 3 has a lower transparent electrode 5 on the upper face of a non-flexible protection panel main body and lower circuits 7a and 7b are provided on the periphery of the lower transparent electrode 5.

The upper electrode sheet 2a has an upper transparent electrode 4 in the position facing to the lower transparent electrode 5 in the under surface of a flexible transparent insulating film and upper circuits 6a to 6d, 7c, and 7d are provided on the periphery of the upper transparent electrode 4.

The decoration sheet 2b is provided with a decoration layer forming a transparent window part 18 in the flexible transparent insulating film while concealing the lower circuits 7a and 7b and the upper circuits 6a to 6d, 7c, and 7d with a picture 17.

As respective transparent electrodes 4 and 5, ITO (indium tin oxide) or the like is rectangularly formed in the inner surface of the upper electrode sheet 2a and the lower electrode panel 3 by sputtering or vacuum deposition.

Strip-shaped bus bars 6a and 6b to be connected with the transparent electrode 4 are formed in parallel using a silver paste on the above-mentioned upper electrode sheet 2a and strip-shaped bus bars 7a and 7b to be connected with the transparent electrode 5 are formed in a direction orthogonal to the bus bars 6a and 6b on the above-mentioned lower electrode panel 3.

The respective bus bars 6a, 6b, 7a, and 7b are gathered at a single point by extending their circuits to a connection part 8 formed in the rim part of the upper electrode sheet 2a.

The above-mentioned decoration sheet 2b is stuck to the entire front surface of the upper electrode sheet 2a (hereinafter, the laminate film of the upper electrode sheet 2a and the decoration sheet 2b is referred to as a movable sheet 2) and when the surface of the decoration sheet 2b is pressed with a finger or a pen, the movable sheet 2 is flexed downward and consequently, the transparent electrodes 4 and 5 formed in the inner surface of the upper electrode sheet 2a and the lower electrode panel 3 are contact with each other to detect the input position.

In addition, in Fig. 3, different from the protection panel with a touch input function for electronic instrument display windows which is disclosed in Pamphlet of International Publication WO 2005/064451, through holes 9a to 9d are formed in the lower electrode panel 3 in parallel to the thickness direction, corresponding to the respective electrode terminals 6c, 7c, 6d, and 7d in the connection part 8. Further, four metal pins 11 to 14 are uprightly installed in a connection-side terminal part 10a of the FPC 10, corresponding to these through holes 9a to 9d to electrically communicate the metal pins 11 to 14 with the electrode terminals 6c, 7c, 6d, and 7d through a conductive adhesive not illustrated. Pamphlet of International Publication WO 2006/077784 discloses such an FPC connection method from the rear face of the lower electrode panel 3.

Regarding the pins-equipped FPC disclosed in Pamphlet of International Publication WO 2006/077784, as show in Fig. 4, metal pin fixation holes are bored in a film substrate 10f and a circuit 10c as a conductive part in the connection-side terminal part 10a of the FPC 10 and the metal pins 11 to 14 each having a pin axis part and a head part formed in a larger diameter than the outer diameter of the pin axis part are to be inserted into the metal pin fixation holes from the circuit side. A cover-lay film 10b is stuck onto the circuit 10c and the film substrate 10f to cover the head parts of the metal pins 11 to 14.

However, there is a drawback that in the FPC 10 connection structure using the metal pins, the circuit 10c and each of the head parts of the metal pins 11 to 14 are connected to each other only by surface contact, and therefore the reliability is low.

More specifically, in a case where the cover-lay film 10b is stuck, it is closely stuck to the metal pins by covering the head parts of the metal pins 11 to 14 in a state of applying pressure and at that time, the film substrate 10f in the surrounding of the metal pin fixation holes is pushed and deformed by the head parts of the metal pins 11 to 14, so that it may sometimes be possible to form a gap between the head parts of the metal pins 11 to 14 and the circuit 10c on the film substrate 10f.

DISCLOSURE OF THE INVENTION

In consideration of the above-mentioned problem of the conventional technique, the present invention provides a protection panel with a touch input function for electronic instrument display windows, which is excellent in the reliability of an FPC connection part.

The present invention is directed to a protection panel with a touch input function for an electronic instrument display window comprising:

a lower electrode panel having a lower transparent electrode on the upper surface of a non-flexible protection panel substrate and lower circuits formed on the periphery of the lower transparent electrode;

an upper electrode sheet having an upper transparent electrode formed in the position facing to said lower transparent electrode in the under surface of a flexible transparent insulating film and upper circuits formed on the periphery of the upper transparent electrode in which the circumferential rim part is stuck to said lower electrode panel such that a gap is formed between electrodes;

a decoration sheet provided with a decoration layer forming a transparent window part on at least one surface of the flexible transparent insulating film while concealing said lower circuits and said upper circuits and stuck to the upper surface of the upper electrode sheet; and

a pin-equipped FPC for taking out electric signals from said electrodes via through holes formed in said lower electrode panel, and

being fitted in a panel fitting part of a casing such that the casing and the outer face of the protection panel are made continuous in a flat top to protect a display apparatus installed under said transparent window part; wherein

said pin-equipped FPC is formed by boring metal pin fixation holes on a film substrate and a circuit as conductive parts in the connection side terminal part, inserting metal pins having head parts in the metal fixation holes from said circuit forming face side, sticking a cover-lay film onto said circuit and said film substrate to cover the head parts of the metal pins, and having a conductive adhesive layer interposed between the circuit of said FPC and the rear face sides of the head parts of said metal pins.

According to the present invention, since the pin-equipped FPC includes, for example, head parts-equipped metal pins each having a pin axis part and a head part formed in a larger diameter than the outer diameter of the pin axis part, and the cover-lay film is stuck onto the circuit and the film substrate to cover the head parts of the metal pins, and the conductive adhesive layer is interposed between the circuit of the FPC and the rear side faces of the head parts of the metal pins, the adhesion of the circuit of the FPC and the head parts of the metal pins can be increased and thus the connection reliability can be improved.

In the present invention, said conductive adhesive layer may be contained an auxiliary conductive filler with a size sufficient to constantly have a contact with both of the circuits of said FPC and the rear side faces of the head parts of said metal pins.

Further, according to the present invention in which the auxiliary conductive filler is added, even if a gap is formed between the circuit of the FPC and the conductive adhesive and/or between the rear side faces of the head parts of the metal pins and the conductive adhesive due to an out gas generated at the time of hardening the conductive adhesive or even if a similar gap is formed due to the stress of the thermal expansion, thermal shrinkage or the like of the film substrate of the FPC and the metal pins at the time of an environment resistance test, electric communication failure can be prevented and thus the reliability of connection can further be improved.

In the present invention, said conductive adhesive layer is made of a conductive adhesive containing 0.001 to 30 wt.% of said auxiliary conductive filler.

Additionally, in the case of said conductive filler is added to said conductive adhesive, it is preferable that viscosity of said conductive adhesive is 10 to 60 N·s/m$^2$ and the specific gravity of said auxiliary conductive filler is 1 to 5.

BRIEF DESCRIPTION OF THE DRAWINGS

Fig. 1 is an enlarged sectional view which illustrates an FPC connection structure of a protective panel with touch input function for electronic instrument display window according to the present invention;

Fig. 2 is an exploded perspective view which illustrates a usage example of a protective panel with touch input function for electronic instrument display window;

Fig. 3 is an exploded perspective view which illustrates a configuration of a protective panel with touch input function for electronic instrument display window;

Fig. 4 is a view equivalent to Fig.1 showing conventional a protective panel with touch input function for electronic instrument display window for comparison;

Fig. 5 is an enlarged sectional view which illustrates an FPC connection method of a protective panel with touch input function for electronic instrument display window according to the present invention;

Fig. 6 is an enlarged sectional view which illustrates an FPC connection part of a protective panel with touch input function for electronic instrument display window according to the present invention;

Fig. 7 is an enlarged sectional view which illustrates an FPC connection part of a protective panel with touch input function for electronic instrument display window according to the present invention;

Fig. 8 is an explanatory diagram which illustrates cracks generated on a surface of a conductive filler;

Fig. 9 is an explanatory diagram which illustrates a conductivity mechanism in the case of cracks generated on a surface of an auxiliary conductive filler;

Fig. 10 is a perspective view which illustrates another application pattern of a conductive adhesive;

Fig. 11 is a perspective view which illustrates another application pattern of a conductive adhesive;

Fig. 12 is a perspective view which illustrates another application pattern of a conductive adhesive.

BEST MODE FOR CARRYING OUT THE INVENTION

Hereinafter, the present invention will be described more in detail based on embodiments shown in drawings.

1. Configuration of a protection panel with a touch input function

The configuration of a protection panel with a touch input function 1 according to the present invention will be described based on Fig. 3.

In Fig. 3, the protection panel with a touch input function 1 includes a lower electrode panel 3 having a lower transparent electrode 5 on the upper surface of a non-flexible protection panel substrate and lower circuits 7a and 7b formed on the periphery of the lower transparent electrode 5; an upper electrode sheet 2a having an upper transparent electrode 4 formed in the position facing to the lower transparent electrode 5 in the under surface of a flexible transparent insulating film and upper circuits 6a to 6d, 7c, and 7d formed on the periphery of the upper transparent electrode 4; and a decoration sheet 2b provided with a decoration layer forming a transparent window part 18 in the flexible transparent insulating film while concealing the lower circuits 7a and 7b and the upper circuits 6a to 6d, 7c, and 7d with a picture 17.

Further, the upper electrode sheet 2a is arranged on the lower electrode panel 3 and the decoration sheet 2b is stuck to the front surface of the upper electrode sheet 2a. The upper electrode sheet 2a and the lower electrode panel 3 are placed opposite such that a gap is formed between the transparent electrodes 4 and 5 and the circumferential rim parts of the electrode sheet 2a and the lower electrode panel 3 are stuck to each other.

Examples of the substrate for the protection panel 1 to be used include a glass plate; an engineering plastic such as a polycarbonate type, polyamide type, and polyether ketone type; a plastic plate such as an acrylic type, polyethylene terephthalate type, and polybutylene terephthalate type and the like.

Further, the lower electrode panel 3 may be obtained by sticking an engineering plastic such as a polycarbonate type, polyamide type; and polyether ketone type; a film such as an acrylic type, polyethylene terephthalate type, or polybutylene terephthalate type in the surface where a lower transparent electrode is to be formed in these plates. That is, after the lower transparent electrode 5 and the lower circuits 7a and 7b are formed on the surface of the film, the film is stuck to the substrate.

Examples of a material for the flexible transparent insulating film of the upper electrode sheet 2a include engineering plastics such as polycarbonate type, polyamide type or polyether keton type; a film such as an acrylic type; polyethylene terephthalate type or polybutylene terephthalate type.

The transparent electrodes 4 and 5 can be formed by using metal oxide films, such as tin oxide, indium oxide, antimony oxide, zinc oxide, cadmium oxide or indium tin oxide(ITO) or composite films mainly composed of these metal oxides or metal films such as gold, silver, copper, tin, nickel, aluminum or palladium.

The transparent electrodes 4 and 5 can be formed into a rectangular shape by using methods such as vacuum deposition, sputtering, ion plating and CVD.

As the upper circuits to be connected with the upper transparent electrode 4, strip-shaped bus bars 6a and 6b are formed in parallel in the above-mentioned upper electrode sheet 2a by using a paste having conductivity of a metal such as gold, silver, copper or nickel or carbon.

On the other hand, as the lower circuits to be connected with the transparent electrode 5, strip-shaped bus bars 7a and 7b are formed in a direction orthogonal to the bus bars 6a and 6b in the above-mentioned lower electrode panel 3.

These strip-shaped bus bars 6a, 6b, 7a, and 7b can be formed by a printing method such as screen printing, off-set printing, gravure printing, or flexo printing; a photoresist method, a brush coating method, or the like.

In addition, the respective bus bars 6a, 6b, 7a, and 7b are gathered at a single point by extending the circuits to a connection part 8 formed in the rim part of the upper electrode sheet 2a.

In Fig. 3, the respective bus bars 6a and 6b of the upper electrode sheet 2a are extended to electrode terminals 6d and 6c of the connection part 8 and the lower circuits extended from the respective bus bars 7a and 7b of the lower electrode panel 3 are to be connected with the electrode terminals 7c and 7d formed in the connection part 8 of the upper electrode sheet 2a in parallel to the electrode terminals 6d and 6c with a conductive adhesive which is not illustrated.

Corresponding to the respective electrode terminals 6c, 7c, 6d, and 7d in this connection part 8, through holes 9a to 9d are formed in the lower electrode panel 3.

Further, corresponding to these through holes 9a to 9d, four metal pins 11 to 14 are uprightly installed in the connection-side terminal parts of an FPC 10 and these metal pins 11 to 14 are to be electrically connected with the electrode terminals 6c, 7c, 6d, and 7d through a conductive adhesive 15 described below.

Furthermore, the decoration sheet 2b forming a transparent window 18 is stuck to the surface of the upper electrode sheet 2a.

This decoration sheet 2b has a picture 17 formed as a decoration layer in one face of a flexile transparent insulating film, for example, an engineering plastic such as a polycarbonate type, polyamide type or polyether ketone type; a film such as an acrylic type, polyethylene terephthalate type or polybutylene terephthalate type, such that the picture 17 conceals the circumference of the transparent window 18, that is the upper circuits and the lower circuits.

As the decoration layer, a colored ink is preferably used. Such a colored ink contains a colorant such as a pigment or dye of any desired color and a binder such as a polyvinyl chloride-type resin, a polyamide-type resin, a polyester-type resin, a polyacrylic-type resin, a polyurethane-type resin, a polyvinyl acetal-type resin, a polyester urethane-type resin, or an alkyd resin.

Examples of a method for forming the decoration layer include conventional printing methods such as screen printing, offset printing, gravure printing or flexo printing. Particularly, in a case where multiple color printing or gradation expression is carried out, offset printing or gravure printing is preferred.

The decoration layer may be formed from a metal thin film layer or a combination of a printing layer and a metal thin film layer.

The metal thin film layer is provided to give metallic luster to the decoration layer, and is formed by, for example, vacuum deposition, sputtering, ion plating, or plating. In this case, according to a desired metallic luster color, metals such as aluminum, nickel, gold, platinum, chromium, iron, copper, tin, indium, silver, titanium, lead, and zinc, or alloys or compounds of two or more of these metals are used.

Usually, film thickness of the metal thin film layer is about 0.05 $\mu$m.

Further, the decoration sheet 2b is stuck to the entire front face of the upper electrode sheet 2a to configure a movable sheet 2.

When the surface of the decoration sheet 2b is pressed with a finger or a pen, the movable sheet 2 is flexed downward and consequently, the transparent electrodes 4 and 5 formed in the inner face of the upper electrode sheet 2a and the lower electrode panel 3 are brought into contact with each other to detect the input position.

Examples of the adhesive layer to be used for sticking the decoration sheet 2b and the upper electrode sheet 2a include polyacrylic-type resins, polystyrene-type resins, or polyamide-type resins, vinyl chloride, vinyl acetate, or acrylic copolymers. Further, a formation method of the adhesive layer 5d includes a common printing method such as screen printing, off-set printing, gravure printing, or flexo printing.

2. FPC connection structure

Next, the FPC connection structure will be described using Fig. 1, an enlarged cross-sectional view.

Fig. 1 shows an enlarged structure of the connection-side terminal part of the FPC 10 and shows a cross-sectional view of the protection panel 1 (assembled state) of Fig. 3 seen from the direction indicated with the arrow A.

In Fig. 1, the reference numeral 16 denotes an adhesive layer for sticking the upper electrode sheet 2a of the movable sheet 2 and the lower electrode panel 3 in their circumferences.

This adhesive layer 16 is required to form the respective connection holes for injecting the conductive adhesive 15 corresponding to the respective electrode terminals 6c, 7c, 6d, and 7d in the connection part 8. That is, the through holes 9a to 9d bored in the lower electrode panel 3 are to be communicated with the respective connection holes to inject the conductive adhesive 15 to the through holes 9a to 9d (see Fig. 3).

For the adhesive layer 16, a frame-like double-faced adhesive tape in which the respective connection holes are circularly punched out while avoiding a part for seeing through a screen of LCD or the like and carrying out touch input (the transparent window 18 in Fig. 3). Further, in place of the double-faced adhesive tape, an insulating adhesive, for example, printing glue such as water-based or acrylic printing glue may be used.

The conductive adhesive 15 may be those obtained by adding a conductive filler to an adhesive using any of a silicone-type, epoxy-type, acrylic-type, urethane-type, or polyester-type resin as a binder.

For the conductive filler, besides a conductive metal powder of such as silver, gold, copper, nickel, platinum, or palladium, those in which as a core material, an inorganic insulator such as alumina or glass, an organic polymer such as polyethylene, polystyrene, or divinylbenzene and the like are used and the surface of the core material is coated with a conductive layer made of such as gold or nickel; carbon; graphite; and the like can be exemplified.

Further, either a thermosetting adhesive or an ultraviolet hardening adhesive may be used as the conductive adhesive 15 and either a one-component adhesive or a two-component adhesive may be used. As an application method of the conductive adhesive 15, a dispenser method is applicable.

Furthermore, the conductive filler may be those having flaky, spherical, or short fiber shapes.

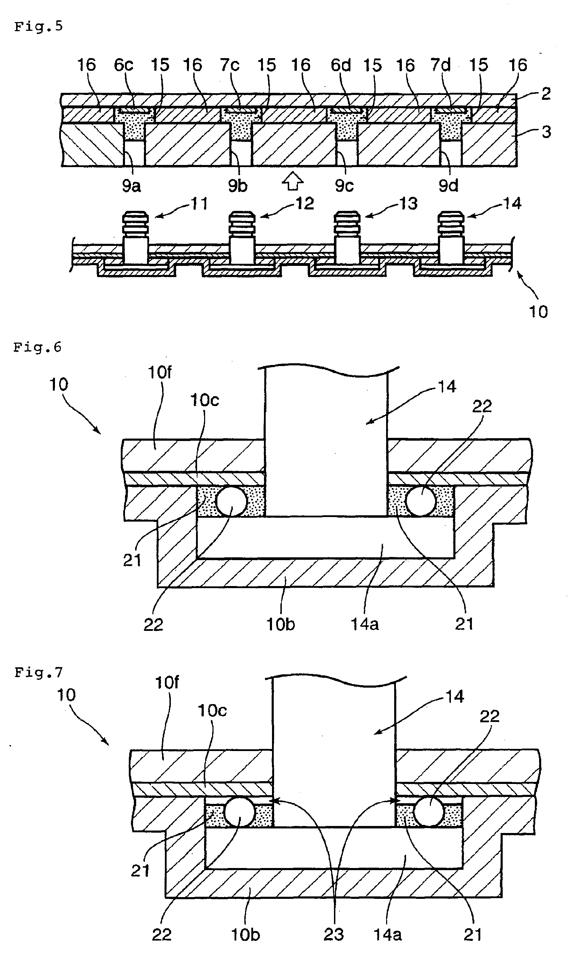

The metal pins 11 to 14 are inserted into the through holes 9a to 9d into which the conductive adhesive 15 is injected and fixed in the lower electrode panel 3 (see Fig. 5).

In the connection-side terminal part 10a of the FPC 10, a metal pin fixation hole 10e is bored in the film substrate 10f and the circuit 10c as a conductive part.

A conductive material, for example, a metal pin 14 made of brass, iron, copper or the like is inserted into the metal pin fixation hole 10e and conventionally, as shown in Fig. 4, the head part 14a of the metal pin 14 in an inserted state is brought into contact with the circuit 10c and accordingly the insertion depth of the neck part (pin axis part) 14b of the metal pin 14 is to be regulated.

On the other hand, the characteristic of the FPC connection structure of the present invention is, as shown in Fig. 1, that a conductive adhesive layer 21 is interposed between the circuit 10c of the FPC 10 and the head part 14a of the metal pin 14, more specifically, the face in the insertion side in the disk-like head part 14a. Owing to such a configuration, the adhesion strength of the circuit 10c of FPC 10 and the head part 14a of the metal pin 14 can be increased, thereby the connection reliability can be enhanced.

Examples of a conductive adhesive 21' (not illustrated) for forming the conductive adhesive layer 21 between the circuit 10c of the FPC 10 and the head part 14a of the metal pin 14 are those exemplified in the explanation of the conductive adhesive 15 to be injected into the through holes 9a to 9d.

An application method of the conductive adhesive 21' may be a dispenser method or the like. The conductive adhesive 21' may be applied to the circuit 10c side of the FPC 10 or to the face of the head insertion side of the metal pin 14, however, it is more preferable to be applied to the circuit 10c side of the FPC 10. It is because a large amount of process by FPC screen printing is possible.

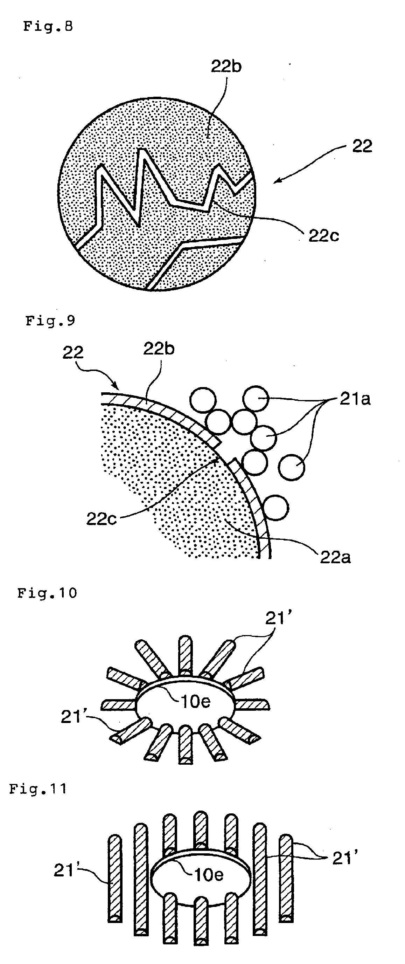

In addition, the conductive adhesive 21' is preferable to be applied circularly; however it may be spread circularly by applying the conductive adhesive 21' radially (see Fig. 10) or in a plurality of strip-like shape (see Fig. 11) and pressing it with the head part 14a. In such a manner, protrusion of the adhesive or short circuit can be suppressed at the time of FPC fabrication.

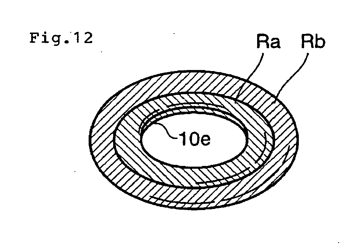

Furthermore, the circular application region may be divided into two concentric regions (see Fig. 12) and, for example, a conductive material having a conduction function may be applied exclusively to the region Ra in the inner side and an adhesive having an adhesion function may be applied exclusively to the region Rb in the outer side to improve both adhesion strength and electrical conductivity.

The circular application region may also be divided into two concentric regions and, the region in the inner circumferential side may be formed by applying the conductive adhesive 21' in a thicker thickness (for example, the inner side thickness 1.1 to 1.5 times as thick as the outer region) to improve the following capability for the deformation of the FPC.

Further, in the FPC 10 in a state where the metal pin 14 is inserted into the metal pin fixation hole 10e, a cover-lay film 10b is stuck to the circuit 10c and the film substrate 10f to cover the head part 14a of the metal pin 14.

This cover-lay film 10b has an object for securing the insulation property and for preventing deterioration by covering the circuit 10c of the FPC 10 and since the film also covers the head part 14a of the metal pin 14 as described above, the fixed power of the metal pin 14 for the circuit 10c can be further increased. Moreover, the insulation property between neighboring metal pins 14 can reliably be attained and also the head part 14a of the metal pin 14 is not exposed to air, so that deterioration due to such as oxidation and corrosion can be prevented.

Although, the connection structure of the FPC 10 and the lower electrode panel 3 is described with the metal pin 14 as a representative in the above description, the connection structures of the FPC 10 and the lower electrode panel 3 using other metal pins 11 to 13 are also the same.

3. Connection structure using a metal pin

As shown in Fig.6, an auxiliary conductive filler 22 for assisting electrical conduction between the circuit 10c and the head part 14a of the metal pin 14 while constantly having a contact with both may be added to the conductive adhesive 21' for forming the conductive adhesive layer 21 between the circuit 10c of the FPC 10 and the head part 14a of the metal pin 14. If the auxiliary conductive filler 22 is added in such a manner, the reliability is further heightened.

As shown in Fig. 7, even if the conductive adhesive layer 21 is a material generating an out gas at the time of hardening and gaps 23 are formed either or both between the circuit 10c of the FPC 10 and the conductive adhesive layer 21 and/or between the head part 14a of the metal pin and the conductive adhesive layer 21 due to the out gas or gaps 23 are formed similarly due to the stress of such as thermal expansion and thermal shrinkage of the film substrate 10f of the FPC 10 and the metal pin 14 at the time of an environment resistance test, since the auxiliary conductive filler 22 constantly has a contact with both of the circuit 10c of the FPC 10 and the rear side face of the head part 14a of the metal pin 14, more specifically, the flat part of the rear side face of the head part 14a, electrical conduction failure can be prevented.

For the electrical conduction mechanism of the conductive adhesive 21', a theory that the conductivity is exhibited by connection of conductive fillers due to volume shrinkage at the time of hardening is propounded. On the other hand, it is also said that since the conductive adhesive 21' contains conductive filler dispersed in a binder and the conductive filler is also surrounded with the binder, which is an insulator, after hardening, the dielectric breakdown is caused among the connected conductive fillers and electrical conduction may be established.

In any case, the conductive filler commonly used for the conductive adhesive 21' (hereinafter, referred to as main conductive filler) may be those which can be very small and are possible to exist in a large number in the thickness direction of the coating of the conductive adhesive 21' such as a flaky or spherical shape material with a particle size of 1 to 20 $\mu$m or a short fiber-like material with a length of 1 to 20 $\mu$m.

Accordingly, in a case where gaps 23 as described above are formed, the reliability of the connection cannot be maintained only by the main conductive filler. Therefore, as shown in Fig. 7, in a case where gaps 23 are formed in the conductive adhesive layer 21, owing to assistance of the auxiliary conductive filler 22, that is, through the auxiliary conductive filler 22, the main conductive filler can maintain the electrical conduction function in the adhesive.

The size of the auxiliary conductive filler 22 may be a size if it can constantly have a contact with both of the circuit 10c of the FPC 10 and the rear side face of the head part 14a of the metal pin 14 after hardening of the conductive adhesive layer 21 and may properly be set in accordance with the thickness of the hardened conductive adhesive layer 21.

For the auxiliary conductive filler 22, besides a conductive metal powder of such as silver, gold, copper, nickel, platinum, or palladium, those in which, as a core material, an inorganic insulator such as alumina or glass, an organic polymer such as polyethylene, polystyrene, or divinylbenzene and the like are used and the surface of the core material is coated with a conductive layer made of such as gold or nickel; carbon; graphite; and the like can be exemplified.

The range of viscosity of the auxiliary conductive filler 21' may be preferably 10 to 60 N·s/m$^2$. In consideration of the dispensing property and screen printability and the dispersibility of the auxiliary conductive filler 22 in the conductive adhesive, it is more preferably 20 to 40 N·s/m$^2$.

If it is less than 10 N·s/m$^2$, the conductive adhesive 21' itself tends to be drooped and thus has a problem of applicability and the dispersed auxiliary conductive filler 22 tends to be precipitated in the fluid dispersion of the conductive adhesive.

On the other hand, if it is higher than 60 N·s/m$^2$, the conductive adhesive 21' itself becomes too hard and thus has a problem of applicability and it becomes difficult to stir for dispersing the auxiliary conductive filler 22.

The specific gravity of the auxiliary conductive filler 22 is preferably about 1 to 5 and more preferably 1 to 3 in consideration of dispersibility of the auxiliary conductive filler 22 in the conductive adhesive 21'.

It is because if the specific gravity is less than 1, the auxiliary conductive filler 22 is easy to float in the dispersion of the conductive adhesive 21' and if the specific gravity is higher than 5, the auxiliary conductive filler 22 tends to be precipitated in the fluid dispersion of the conductive adhesive 21'.

Further, the auxiliary conductive filler 22 is preferable to be formed in spherical shape. If it is made to be spherical, since the length in the radius direction is constant, the circuit 10c of the FPC 10 and the rear side face of the head part 14a of the metal pin 14 can reliably be brought into contact with each other even if the auxiliary conductive filler 22 is dispersed in any state.

In contrast, in a case where the auxiliary conductive filler 22 is made to be, for example, flaky, since the thickness dimension is extremely small as compared with the dimensions in the vertical and transverse lengths, the circuit 10c of the FPC 10 and the rear side face of the head part 14a of the metal pin 14 may not sometimes reliably be brought into contact with each other in accordance with the dispersion state.

Further, in consideration of the dispersibility of the auxiliary conductive filler 22 in the conductive adhesive 21', the auxiliary conductive filler 22 is preferably contained in an amount of 0.001 to 30 wt.% based on the weight of the conductive adhesive at the time of ink manufacturing.

It is because the auxiliary conductive filler 22 is necessary to be added in an amount of 0.001 wt.% or higher based on the weight of the conductive adhesive 21' at the time of ink manufacturing in order to add at least one auxiliary conductive filler 22 particles to the conductive adhesive layer 21 in the respective connection parts of the FPC 10.

If it is less than 0.001 wt.%, a case where even a single particle of the auxiliary conductive filler 22 cannot exist in the respective connection parts may possibly occur. Further, if the content of the auxiliary conductive filler 22 exceeds 30 wt.%, the repulsion to electrodes becomes large due to elastic force of the auxiliary conductive filler 22 or the adhesion strength of the conductive adhesive 21' itself may be decreased or the viscosity may become too high.

It is for this reason that the auxiliary conductive filler 22 is not added alone to the conductive adhesive layer 21 but added together with the main conductive filler.

The content of the above-mentioned auxiliary conductive filler in the conductive adhesive 21' is 0.001 to 60 wt. % at the time of dried condition.

On the other hand, it is necessary to add the main conductive filler in an amount of 20 to 80 wt.% based on the weight of the conductive adhesive at the time of ink manufacturing.

If the content of the main conductive filler is less than 20 wt.%, the loss by electric resistance becomes high in the connection parts. If the content of the main conductive filler exceeds 80 wt.%, the viscosity becomes high and consequently, the flexibility becomes poor and the ink manufacturing becomes difficult. In the conductive adhesive layer 21, flexibility is required so as to endure a certain extent of stresses.

The content of the main conductive filler in the conductive adhesive 21' is 20 to 95 wt.% at the time of dried condition.

Further, it is preferable that the auxiliary conductive filler 22 is constituted with a truly spherical core material 22a made of a plastic and a conductive layer 22b formed by metal plating and that the particle size of the auxiliary conductive filler 22 is made slightly larger than the shortest distance of the connection-surface spacing between the circuit 10c of the FPC 10 and the rear side face of the head part 14a of the metal pin 14 to be connected with the conductive adhesive layer 21.

In a case where the surface of the core material 22a made of a plastic is coated with the conductive layer 22b by metal plating and the particle size of the auxiliary conductive filler 22 is made slightly larger than the connection-surface spacing, it is made possible to easily deform the auxiliary conductive filler 22 in accordance with the compression load and to bring the auxiliary conductive filler 22 into plane-contact with the circuit 10c of the FPC 10 and the rear side face of the head part 14a of the metal pin 14.

If the auxiliary conductive filler 22 is brought into plane-contact with the circuit 10c of the FPC 10 and the rear side face of the head part 14a of the metal pin 14, the electrical conduction can be stabilized, being different from that in the case of a point contact.

In consideration of the contact surface area of spherical bodies in a case where the particle size is compressed by about 10 to 20%, regarding the respective contact surface areas of the bottom surface and the top surface, about 19 to about 36% of the maximum cross section can contribute to the contact according to the following calculation. That is, in a case where X denotes the radius of the portion compressed and made flat:

$$X^2 = R^2 - Y^2$$

wherein R denotes the radius [μm] of the spherical body; Y denotes R - one sided compression degree [μm], and the deformation quantity from the spherical body to an elliptical body is neglected.

$$X^2 = 50^2 - 45^2 \text{ (10\% compression of spherical body with a diameter of 100 μm)}$$

and thus

$$X = 21.8$$

Accordingly, the ratio of the surface area calculated as $21.8 \times 21.8 \times \pi$ to the maximum cross section, which is $50 \times 50 \times \pi$, is 19%.

However, if the particle size of the auxiliary conductive filler 22 becomes larger exceeding 50 μm than the shortest distance of the connection-surface spacing, only the connection part is abnormally elevated and thus electrical conduction failure or peeling of the circuit may possibly be caused and therefore, the particle size of the auxiliary conductive filler 22 is preferably made large in a range of 1 to 50 μm.

In addition, if the auxiliary conductive filler 22 is obtained by coating the insulating core material 22a with the conductive layer 22b and has a larger particle size than the shortest distance of the connection-surface spacing, as shown in Fig. 8, cracks 22c or peeling may sometimes be formed in the conductive layer 22b by the fixing and stabilizing strength (due to the ultrasonic vibration and pressure described below) at the time of the pin-equipped FPC connection. However, even in such a case, since the main conductive filler 21 a covers the auxiliary conductive filler 22 while adhering to the surface of the auxiliary conductive filler 22, electrical conduction can be attained through the main conductive filler 21a (see Fig. 9).

For the auxiliary conductive filler 22, those coated with gold as the conductive layer 22b are preferable. It is because the auxiliary conductive filler 22 in which the surface is coated with gold is good in the dispersibility in a binder and also excellent in the electrical conductivity of the conductive layer 22b and mechanical strength.

For example, the specific gravity of the auxiliary conductive filler 22 with a diameter of 100 μm and having a gold coating is 1.43 and thus the specific gravity is extremely small as compared with that (specific gravity about 19) of the filler consist only of a gold. Additionally, in a case where the auxiliary conductive filler 22 is obtained by coating the core material 22a made of a plastic with the conductive layer 22b, as compared with a filler consist only of a metal, it is advantageous that truly spherical shape can be obtained easily by producing the core material 22a by polymerization. It results in that the filler is not precipitated even in a relatively high concentrated binder and exhibits excellent dispersion stability.

Specifically, in a case where an ink is manufactured by blending the auxiliary conductive filler 22 having a spherical shape with a particle size of 100 μm and a specific gravity of 1.43 in an amount of 1.5 wt.% based on the weight of the conductive adhesive and stirred and thereafter, the ink is applied in form of spots with a surface area of 1 mm φ by a dispenser, 10 particles on average and 3 particles in the minimum of the auxiliary conductive filler 22 can be dispersed without causing cohesion.

On the other hand, the main conductive filler to be added to the conductive adhesive 21' is more preferably a flaky silver powder. It is because silver has specific resistance lower than that of copper or the like and is thus easy to lower the resistance for a relatively small content and thus the viscosity also becomes low. Further, the flaky shape is advantageous in that the contact surface area of the main conductive fillers and the contact surface area between the main conductive filler and the auxiliary conductive filler 22 can be improved.

4. Insertion means for a metal pin

Finally, as a means for inserting the metal pins 11 to 14, as shown in Fig. 5, it is preferable to employ, for example, a method of setting the respective hole diameters of the through holes 9a to 9d to be diameters equal to or smaller than the outer diameters of the metal pins 11 to 14 by about 30% and the axis parts of the metal pins 11 to 14 are pressure-inserted to the through holes 9a to 9d while applying ultrasonic vibration and pressure to the head parts of the metal pins 11 to 14 with an ultrasonic insertion apparatus.

It is because according to a method of using the ultrasonic insertion apparatus, friction heat is generated locally in the boundary faces of the respective axis parts of the metal pins 11 to 14 and the through holes 9a to 9d and the metal pins 11 to 14 are inserted while the resin forming the wall faces of the through holes 9a to 9d being melted and due to re-hardening, firm fixation can be obtained.

Further, with respect to a method for fixing the metal pins 11 to 14 in the through holes 9a to 9d of the lower electrode panel 3, it is not limited to the method by the ultrasonic insertion but a conductive adhesive 15 may be used. In this case, if the respective diameters of the through holes 9a to 9d to be formed in the lower electrode panel 3 are set to be wider in a range of 50 to 100 μm than the outer diameters of the metal pins 11 to 14 and the metal pins 11 to 14 are inserted into the through holes 9a to 9d, the conductive adhesive 15 is allowed to flow into the gaps between the through holes 9a to 9d and the neck parts 11b to 14b of the metal pins 11 to 14.

EXAMPLES

Example 1

An ITO film with a thickness of 20 nm was formed by sputtering on the entire one face of a PET film with a thickness of 0.1 mm and the periphery part of the ITO film was removed to give a transparent electrode with a wide rectangular shape.

Further, for bus bars arranged in two sides facing to each other in the transverse direction of the transparent electrode and a lead-out wire for external output of the respective bus bars, a silver paste was formed by screen printing.

After an acrylic plate with a thickness of 0.7 mm and the same dimensions as the vertical and transverse sizes of the PET film was stuck to the reverse side of the PET film where the transparent electrode was formed with a transparent adhesive with a thickness of 0.025 mm, four through holes with a diameter of 1.5 mm for inserting the pin axes of a pin-equipped FPC described below were bored by a drilling method to obtain a lower electrode panel.

Using a PET film with a thickness of 125 $\mu$m and the same dimensions as the vertical and transverse sizes of the lower electrode panel, an ITO film with a thickness of 20 nm was formed by sputtering on the entire one face of the PET film and the periphery part of the ITO film was removed to give a transparent electrode with a wide rectangular shape. Further, for bus bars arranged in two sides facing to each other in the transverse direction of the transparent electrode and a lead-out wire for external output of the respective bus bars, a silver paste was formed by screen printing to obtain an upper electrode sheet.

Further, using PET substrate hard coat film with a thickness of 0.075 mm and the same dimensions as the vertical and transverse sizes of the lower electrode panel, a decoration layer having a transparent window part in the reverse face to the hard coat face was formed by gravure printing to obtain a decoration sheet.

Next, the face in the above-mentioned decoration layer side of the decoration sheet was stuck to the reverse face to the transparent electrode side of the upper electrode sheet via a transparent adhesive with a thickness of 0.025 mm to obtain a movable sheet.

Thereafter, the lower electrode panel and the upper electrode sheet were placed opposite such that the electrodes formed respectively were kept at a distance and were stuck to each other by using a double-faced adhesive tape in a frame-like shape formed by punching the transparent window part and the respective connection holes and the resultant was cut along the inner circumferential rim of the decoration layer.

On the other hand, in the connection side terminal part of the FPC obtained by forming a circuit as a conductive part using a silver paste on one face of a polyimide film with a thickness of 0.075 mm, metal pin fixation holes with a diameter of 2.0 mm were bored at four points by drilling.

An ink made of a conductive adhesive for forming a conductive adhesive layer 21 is applied by screen printing around the metal pin fixation holes.

This conductive adhesive was obtained by mixing a main conductive filler made of a flaky silver powder with a particle size of 10 $\mu$m in a weight ratio of 50 wt.% with a binder made of a polyester resin and at the same time mixing an auxiliary conductive filler in a weight ratio of 2.0 wt.%. In addition, the auxiliary conductive filler was obtained by coating an insulating crosslinked copolymer resin beads containing divinylbenzene as a main component with a conductive layer made of gold by plating and had a spherical shape with a particle size of 100 $\mu$m.

Next, the metal pins having a pin axis with a diameter of 1.8 mm and a length of 1 mm and a pin head with a diameter of 2.8 mm and a thickness of 0.3 mm were inserted from the face of the circuit side of the FPC and pressurized to thermally harden the conductive adhesive in a state where the circuit of the FPC and the rear face sides of the head parts of the metal pins were brought into plane-contact with each other through the auxiliary conductive filler.

Further, a polyimide film with a thickness of 0.05 mm was stuck to cover the circuit of the FPC and the head parts of the metal pins to obtain a pin-equipped FPC.

Thereafter, an ink made of the conductive adhesive 15 was injected into the through holes bored in the lower electrode panel as shown in Fig. 5 by a dispenser and successively the metal pins 11 to 14 of the pin-equipped FPC were positioned in the inlets of the through holes 9a to 9d. The above-mentioned conductive adhesive 15 was obtained by mixing a main conductive filler made of a flaky silver powder with a particle size of 10 $\mu$m in a weight ratio of 50 wt. % with a binder made of a silicone resin.

Finally, while ultrasonic vibrations and pressure being applied to the head parts of the metal pins by an ultrasonic insertion apparatus, the axis parts of the metal pins were pressure-inserted into the through holes and thus while the resin forming the wall faces of the through holes bored in the lower electrode panel being melted by the respective axis parts of the metal pins, the metal pins were inserted to obtain a protection panel.

The protection panel thus produced enabled the touch input in a display window of an electronic instrument such as a mobile phone and was excellent in the connection reliability in the FPC connection parts.

In addition, among the above various embodiments, arbitrary embodiments may properly be combined to exert effects included in each embodiment.

Although the present invention has been sufficiently described relating to the preferred embodiments while referring to the attached drawings, it is also possible for those skilled in the art to carry out the present invention with various variations and alterations, and the variations and alterations should be construed to be encompassed in the technical range of the present invention as long as they are not departing from the scope of the claims of the present invention.

INDUSTRIAL APPLICABILITY

The present invention is suitable as a protection panel for display windows of portable information terminals such as PDA and handy terminals, OA appliances such as copying machines and facsimiles, smart phones, mobile phones, portable game consoles, electronic dictionaries, automotive navigation systems, compact PC, various kinds of home electric appliances, etc.

**Claims**

1.  A protection panel with a touch input function for an electronic instrument display window comprising:

    a lower electrode panel having a lower transparent electrode on the upper face of a non-flexible protection panel substrate and lower circuits formed on the periphery of the lower transparent electrode;
    an upper electrode sheet having an upper transparent electrode formed in the position facing to said lower transparent electrode in the under surface of a flexible transparent insulating film and upper circuits formed on the periphery of the upper transparent electrode in which the circumferential rim part is stuck to said lower electrode panel such that a gap is formed between electrodes;
    a decoration sheet provided with a decoration layer forming a transparent window part on at least one surface of the flexible transparent insulating film while concealing said lower circuits and said upper circuits and stuck to the upper surface of the upper electrode sheet; and
    a pin-equipped FPC for taking out electric signals from said electrodes via through holes formed in said lower electrode panel, and
    being fitted in a panel fitting part of a casing such that the casing and the outer face of the protection panel are made continuous in a flat top to protect a display apparatus installed under said transparent window part; wherein said pin-equipped FPC is formed by boring metal pin fixation holes on a film substrate and a circuit as conductive parts in the connection side terminal part, inserting metal pins having head parts in the metal fixation holes from said circuit forming face side, sticking a cover-lay film onto said circuit and said film substrate to cover the head parts of the metal pins, and having a conductive adhesive layer interposed between the circuit of said FPC and the rear face sides of the head parts of said metal pins.

2.  The protection panel with a touch input function for an electronic instrument display window according to claim 1, wherein said conductive adhesive layer contains an auxiliary conductive filler with a size sufficient to constantly have a contact with both of the circuits of said FPC and the rear side faces of the head parts of said metal pins.

3.  The protection panel with a touch input function for an electronic instrument display window according to claim 2, wherein said conductive adhesive layer is made of a conductive adhesive containing 0.001 to 30 wt.% of said auxiliary conductive filler.

4.  The protection panel with a touch input function for an electronic instrument display window according to claim 3, wherein the viscosity of said conductive adhesive is 10 to 60 N·s/m$^2$ and the specific gravity of said auxiliary conductive filler is 1 to 5.

Fig.1

Fig.2

Fig.3

Fig.4

Fig.5

Fig.6

Fig.7

Fig.8

Fig.9

Fig.10

Fig.11

Fig. 12

## INTERNATIONAL SEARCH REPORT

International application No.

PCT/JP2008/055398

A. CLASSIFICATION OF SUBJECT MATTER
*G06F3/041(2006.01)i, G06F3/045(2006.01)i, H01H13/04(2006.01)i, H01H13/712
(2006.01)i*

According to International Patent Classification (IPC) or to both national classification and IPC

B. FIELDS SEARCHED

Minimum documentation searched (classification system followed by classification symbols)
G06F3/03-3/047, H01H13/04, 13/712, H01R9/03-9/11, 12/04-12/08,
12/32-12/38, H05K1/14, 3/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2005/064451 A1 (NISSHA Printing Co., Ltd.), 14 July, 2005 (14.07.05), Full text; all drawings & EP 1698965 A1 & US 2007/0181456 A1 | 1-4 |
| Y | WO 2006/077784 A1 (NISSHA Printing Co., Ltd.), 27 July, 2006 (27.07.06), Full text; all drawings (Family: none) | 1-4 |
| Y | JP 10-335811 A (NEC Home Electronics Ltd.), 18 December, 1998 (18.12.98), Full text; all drawings (Family: none) | 1-4 |

| ☒ Further documents are listed in the continuation of Box C. | ☐ See patent family annex. |
|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 May, 2008 (07.05.08) | 20 May, 2008 (20.05.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/055398

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-182849 A (Shin-Etsu Polymer Co., Ltd.), 28 June, 2002 (28.06.02), Par. No. [0027] (Family: none) | 1-4 |
| Y | JP 2001-60142 A (NISSHA Printing Co., Ltd.), 06 March, 2001 (06.03.01), Full text; all drawings & WO 2000/079475 A2 & US 6847355 B1 | 2-4 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005064451 A
- WO 2006077784 A